# EUROPEAN PATENT APPLICATION

(11) **EP 1 981 086 A1**
(43) Date of publication of application: **15.10.2008**
(21) Application number: 07707236.1
(22) Date of filing: 23.01.2007
(51) Int. Cl.: H01L 29/786, H01L 21/336

(54) **THIN FILM TRANSISTOR, AND ACTIVE MATRIX SUBSTRATE AND DISPLAY DEVICE PROVIDED WITH SUCH THIN FILM TRANSISTOR**

(30) Priority: 30.01.2006 JP 2006020600
(71) Applicant: Sharp Kabushiki Kaisha, Osaka-shi, Osaka 545-8522 (JP)
(72) Inventor: OKADA, Yoshihiro, Kanagawa 250-0012 (JP); NAKAMURA, Wataru, Kyoto 619-0024 (JP); BAN, Atsushi, Nara 631-0001 (JP)
(74) Representative: Brown, Kenneth Richard
(86) International application number: PCT/JP2007/050973
(87) International publication number: WO 2007/086368

(57) **Abstract**

Improves the electric current driving capability of a thin film transistor without the yield being decreased due to a defective leak between a source electrode/drain electrode and a gate electrode or due to a decrease in an off-characteristic.

A thin film transistor according to the present invention includes a gate electrode; an insulating film covering the gate electrode; a semiconductor layer provided on the insulating film; and a source electrode and a drain electrode provided on the insulating film and the semiconductor layer. The insulating film is a multiple layer insulating film including a first insulating layer and a second insulating layer provided on the first insulating layer. The multiple layer insulating film has a low stacking region excluding the first insulating layer and a high stacking region in which the first insulating layer and the second insulating layer are stacked. The first insulating layer is provided so as to cover at least an edge of the gate electrode. The semiconductor layer is provided on both the low stacking region and the high stacking region of the multiple layer insulating film. The semiconductor layer and the low stacking region are arranged such that a path of a current flowing between the source electrode and the drain electrode necessarily passes a part of the semiconductor layer which is located above the low stacking region.

## Description

### TECHNICAL FIELD

The present invention relates to a thin film transistor. The present invention also relates to an active matrix substrate and a display device including the thin film transistor.

### BACKGROUND ART

Liquid crystal display devices have features of being thin and consuming low power and so are widely used in a variety of fields. Especially, active matrix liquid crystal display devices including a thin film transistor (referred to simply as a "TFT") for each pixel provide a high level of performance with a high contrast ratio and a superb response characteristic, and so are used in TVs, monitors and notebook computers. The market of the active matrix liquid crystal display devices has been expanding recently.

On an active matrix substrate used in an active matrix liquid crystal display device, a plurality of scanning lines and a plurality of signal lines crossing the scanning lines with an insulating film interposed therebetween are provided. In the vicinity of an intersection of each scanning line and each signal line, a thin film transistor for driving a pixel is provided.

Recently, liquid crystal display devices for TVs have been rapidly increasing in size. When the resolution is the same, a larger liquid crystal display device has larger pixels. Therefore, the electric current driving capability of the thin film transistor provided for driving the pixel needs to be improved.

Techniques for improving the electric current driving capability of a thin film transistor are, for example, to increase the size of the thin film transistor or to improve the quality of the amorphous silicon semiconductor film used to form a semiconductor structure.

However, the technique of increasing the size of the thin film transistor inevitably increases the channel width, and thus has a problem that the yield is decreased due to, for example, a defective leak between the source electrode and the drain electrode or a defective leak between the source electrode/drain electrode and a gate electrode. Increasing the size of the thin film transistor also has a problem that the light utilization factor is decreased. The technique of improving the quality of the amorphous silicon semiconductor film is not expected to provide a significant improvement in the electric current driving capability because the quality of the amorphous silicon semiconductor film has now reached the highest possible level on the production level.

It is conceivable to improve the electric current driving capability by thinning the gate insulating film. However, simply thinning the gate insulating film results in an increase in the capacitance generated at an intersection of the scanning line and the signal line (referred to as a "parasitic capacitance"), which lowers the display quality.

Patent Document 1 discloses a thin film transistor in which the gate insulating film has a two-layer structure formed of two insulating layers, and a part of the gate insulating film which is located below the amorphous silicon semiconductor film has a single-layer structure. Patent Document 1 does not have an object of improving the electric current driving capability of the thin film transistor, but such a structure is considered to be usable to thin the gate insulating film without increasing the parasitic capacitance and thus to improve the electric current driving capability of the thin film transistor.
Patent Document 1: Japanese Patent No. 2956380

### DISCLOSURE OF THE INVENTION

### PROBLEMS TO BE SOLVED BY THE INVENTION

However, as a result of a detailed examination, the present inventors found that when the gate insulating film is thinned using the structure disclosed in Patent Document 1, the following occurs: a defective leak between the source electrode/drain electrode and the gate electrode is rapidly increased, which rather decreases the yield; and an off-current exceeding 10 pA flows and so the source electrode and the drain electrode cannot be electrically separated from each other. As understood from the above, use of the structure disclosed in Patent Document 1 decreases the yield due to a defective leak or a decrease in the off-characteristic.

The present invention made in light of the above-described problems has an object of improving the electric current driving capability of a thin film transistor without decreasing the yield due to a defective leak between the source electrode/drain electrode and the gate electrode or due to a decrease in the off-characteristic.

### MEANS FOR SOLVING THE PROBLEMS

A thin film transistor according to the present invention includes a gate electrode; an insulating film covering the gate electrode; a semiconductor layer provided on the insulating film; and a source electrode and a drain electrode provided on the insulating film and the semiconductor layer. The insulating film is a multiple layer insulating film including a first insulating layer and a second insulating layer provided on the first insulating layer. The multiple layer insulating film has a low stacking region excluding the first insulating layer and a high stacking region in which the first insulating layer and the second insulating layer are stacked. The first insulating layer is provided so as to cover at least an edge of the gate electrode. The semiconductor layer is provided on both the low stacking region and the high stacking region of the multiple layer insulating film. The semiconductor layer and the low stacking region are arranged such that a path of a current flowing between the source electrode and the drain electrode necessarily passes a part of the semiconductor layer which is located above the low stacking region. By this, the above-described object is achieved.

In a preferable embodiment, the path of the current, in the part of the semiconductor layer which is located above the low stacking region, is away from the high stacking region by at least 0.5 µm.

In a preferable embodiment, the semiconductor layer has a cutout portion extending in a direction of a channel width.

In a preferable embodiment, a width of the low stacking region in a direction of a channel width is larger than a width of the semiconductor layer in the direction of the channel width.

In a preferable embodiment, the low stacking region has a projection which projects in a direction of a channel width.

Alternatively, a thin film transistor according to the present invention includes a gate electrode; an insulating film covering the gate electrode; a semiconductor layer provided on the insulating film; and a source electrode and a drain electrode provided on the insulating film and the semiconductor layer. The insulating film is a multiple layer insulating film including a first insulating layer and a second insulating layer provided on the first insulating layer. The multiple layer insulating film has a low stacking region excluding the first insulating layer and a high stacking region in which the first insulating layer and the second insulating layer are stacked. The first insulating layer is provided so as to cover at least an edge of the gate electrode. The semiconductor layer is provided on both the low stacking region and the high stacking region of the multiple layer insulating film, and has an area having a smaller width than the low stacking region in a direction of a channel width.

In a preferable embodiment, the semiconductor layer overlaps a part of the source electrode and a part of the drain electrode which overlap the low stacking region.

In a preferable embodiment, the part of the source electrode which overlaps the low stacking region has a smaller area size than the part of the drain electrode which overlaps the low stacking region.

In a preferable embodiment, the first insulating layer is formed of an insulating material containing an organic component, and the second insulating layer is formed of an inorganic insulating material.

In a preferable embodiment, the first insulating layer is thicker, and has a lower specific dielectric constant, than the second insulating layer.

In a preferable embodiment, the first insulating layer has a thickness of 1.0 µm or greater and 4.0 µm or less.

In a preferable embodiment, the first insulating layer is formed of a spin-on glass (SOG) material having a specific dielectric constant of 4.0 or less.

An active matrix substrate according to the present invention includes a substrate; a plurality of thin film transistors having the above-described structure which is provided on the substrate; a plurality of scanning lines electrically connected respectively to gate electrodes of the plurality of thin film transistors; and a plurality of signal lines electrically connected respectively to source electrodes of the plurality of thin film transistors.

A display device according to the present invention includes the active matrix substrate having the above-described structure.

### EFFECTS OF THE INVENTION

According to the present invention, the electric current driving capability of a thin film transistor can be improved without the yield being decreased due to a defective leak between the source electrode/drain electrode and the gate electrode or due to a decrease in the off-characteristic.

### BRIEF DESCRIPTION OF THE DRAWINGS

[FIG. 1] FIG. **1** is a plan view schematically showing a liquid crystal display device **100** according to an embodiment of the present invention.
[FIG. 2] FIG. **2** is a cross-sectional view schematically showing the liquid crystal display device 100, taken along line **2A-2A'** of FIG. **1****.**
[FIG. 3] FIGS. **3(a)** through (**c**) are cross-sectional views schematically showing a TFT substrate **100a** of the liquid crystal display device **100**, respectively taken along lines **3A-3A', 3B-3B'** and **3C-3C'** of FIG. **1****.**
[FIG. 4] FIG. **4** is a plan view schematically showing a thin film transistor **14** according to an embodiment of the present invention.
[FIG. 5] FIG. **5** is a plan view schematically showing a thin film transistor **14'** in a comparative example.
[FIG. 6] FIG. **6** is a graph showing the relationship between the gate voltage Vgs (V) and the drain current Ids (A) of the TFT **14** shown in FIG. **4** and the TFT **14'** shown in FIG. **5****.**
[FIG. 7] FIG. **7** is a plan view schematically showing another thin film transistor **14** according to an embodiment of the present invention.
[FIG. 8] FIG. **8** is a plan view schematically showing still another thin film transistor **14** according to an embodiment of the present invention.
[FIG. 9] FIG. **9** is a graph showing the relationship between the distance (µm) of the channel region from the high stacking region of the multiple layer insulating film and the off-current I_{off} (A), regarding the thin film transistor.
[FIG. 10] FIGS. **10(a)** through **(f)** are cross-sectional views schematically showing production steps of the TFT substrate **100a.**
[FIG. 11] FIG. **11** is a plan view schematically showing a liquid crystal display device **100** according to an embodiment of the present invention.
[FIG. 12] FIG. **12** is a cross-sectional view schematically showing a part of the liquid crystal display device **100** in the vicinity of a shield electrode **23,** taken along line **12A-12A'** of FIG. **11****.**
[FIG. 13] FIG. **13** is a plan view schematically showing still another thin film transistor **14** according to an embodiment of the present invention.
[FIG. 14] FIG. **14** is a plan view schematically showing still another thin film transistor **14** according to an embodiment of the present invention.
[FIG. 15] FIG. **15** is a plan view schematically showing still another thin film transistor **14** according to an embodiment of the present invention.
[FIG. 16] FIG. **16** is a plan view schematically showing still another thin film transistor **14** according to an embodiment of the present invention.

### DESCRIPTION OF THE REFERENCE NUMERALS

- **10**: Substrate (transparent insulating substrate)
- **11**: Scanning line
- **12**: Insulating film (multiple layer insulating film)
- **12a**: First insulating layer
- **12b**: Second insulating layer
- **12R**: Low stacking region
- **13**: Signal line
- **14**: Thin film transistor (TFT)
- **14G**: Gate electrode
- **14S**: Source electrode
- **14D**: Drain electrode
- **15**: Pixel electrode
- **16**: Gate insulating film
- **17**: Semiconductor layer (intrinsic semiconductor layer)
- **17a**: Source region
- **17b**: Drain region
- **17c**: Channel region
- **18**: Impurity added semiconductor layer
- **19**: Inter-layer insulating film
- **19'**: Contact hole
- **20**: Storage capacitance line
- **21**: Storage capacitance electrode
- **22**: Conductive member
- **23**: Shield electrode
- **60**: Liquid crystal layer
- **100**: Liquid crystal display device
- **100a**: Active matrix substrate (TFT substrate)

### BEST MODE FOR CARRYING OUT THE INVENTION

Hereinafter, embodiments of the present invention will be described with reference to the drawings. The present invention is not limited to the following embodiments.

(EMBODIMENT 1)

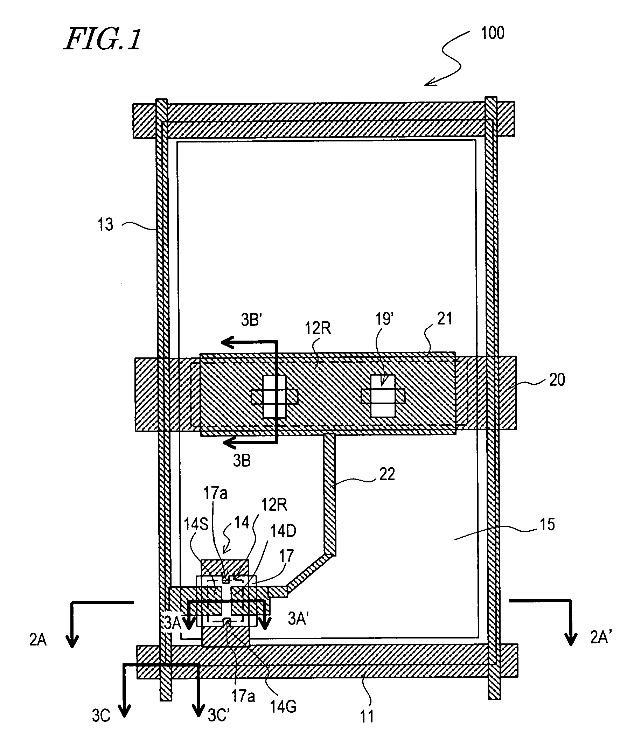

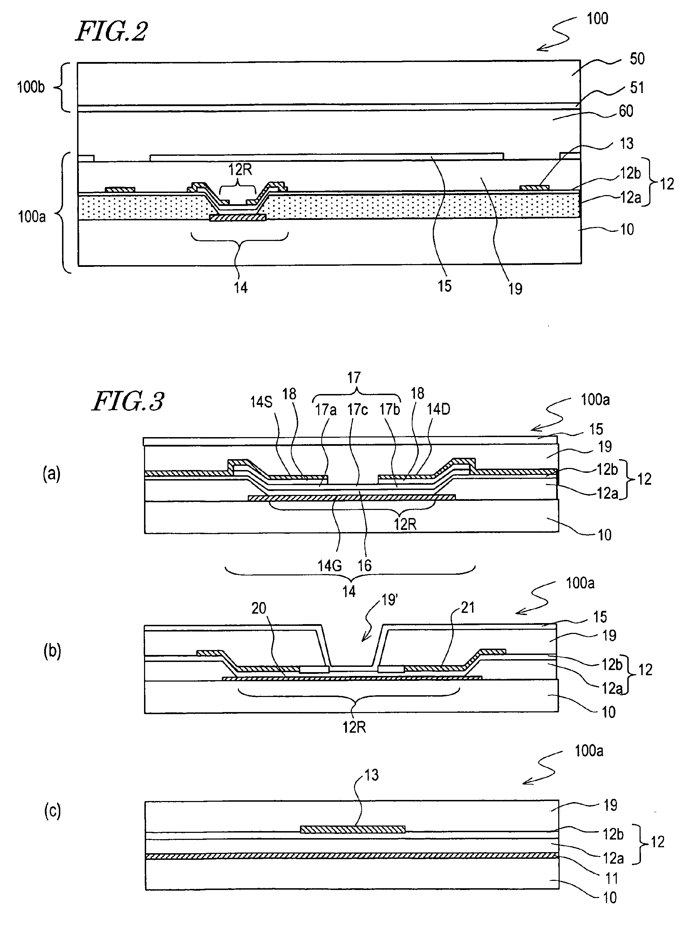

FIGS. **1** and **2** show a liquid crystal display device **100** according to this embodiment. FIG. **1** is a plan view schematically showing one pixel area of the liquid crystal display device **100,** and FIG. **2** is a cross-sectional view taken along line **2A-2A'** of FIG. **1****.**

The liquid crystal display device **100** includes an active matrix substrate (hereinafter, referred to as a "TFT substrate") **100a,** a counter substrate (also referred to as a "color filter substrate") **100b** facing the TFT substrate **100a**, and a liquid crystal layer **60** provided between the TFT substrate **100a** and the counter substrate **100b.**

The TFT substrate **100a** includes a transparent insulating substrate (for example, a glass substrate) **10,** a plurality of scanning lines **11** provided on the substrate **10,** an insulating film **12** covering the scanning lines **11,** and a plurality of signal lines **13** crossing the scanning lines **11** with the insulating film **12** interposed therebetween.

The TFT substrate **100a** further includes a thin film transistor (TFT) **14** operating in response to a signal applied to the corresponding scanning line **11** and a pixel electrode **15** electrically connectable with the corresponding signal line **13** via the TFT **14** which acts as a switching element. The thin film transistor (TFT) **14** and the pixel electrode **15** are both provided for each pixel area.

The counter substrate **100b** includes a transparent insulating substrate (for example, a glass substrate) **50** and a counter electrode **51** provided on the substrate **50** and facing the pixel electrode **15.** Typically, the counter substrate **100b** further includes a color filter.

The liquid crystal layer **60** changes an orientation state thereof in accordance with the voltage applied between the pixel electrode **15** and the counter electrode **51** and thus modulates the light passing through the liquid crystal layer **60.** In this way, display is provided. As the liquid crystal layer **60,** a liquid crystal layer of any of a wide variety of display modes is usable. For example, a liquid crystal layer of a TN (Twisted Nematic) mode using an optical rotatory power or a liquid crystal layer of an ECB (Electrically Controlled Birefringence) mode using birefringence is usable. Among ECB modes, a VA (vertically aligned) mode can realize a high contrast ratio. A liquid crystal layer of a VA mode is typically obtained by providing a vertical alignment layer on both sides of a liquid crystal layer which contains a liquid crystal material having a negative dielectric anisotropy.

Hereinafter, referring to FIG. **3** as well as FIGS. **1** and **2****,** a structure of the TFT substrate **100a** will be described in more detail. FIGS. **3(a), (b)** and **(c)** are respectively cross-sectional views taken line lines **3A-3A', 3B-3B'** and **3C-3C'** of FIG. **1****.**

As shown in FIG. **3(a)****,** the TFT **14** of the TFT substrate **100a** includes a gate electrode **14G** electrically connected to the scanning line **11,** a source electrode **14S** electrically connected to the signal line **11,** and a drain electrode **14D** electrically connected to the pixel electrode **15.**

The TFT **14** has a stacking structure in which the gate electrode **14G,** a gate insulating film **16,** an intrinsic semiconductor layer (hereinafter, also referred to simply as a "semiconductor layer") **17** and an impurity added semiconductor layer **18** stacked from the bottom. A source region **17a** and a drain region **17b** of the semiconductor layer **17** are electrically connected to the source electrode **14S** and the drain electrode **14D** respectively, via the impurity added semiconductor layer **18** acting as a contact layer. In the semiconductor layer **17,** an area between the source region **17a** and the drain region **17b** acts as a channel region **17c,** and the impurity added semiconductor layer **18** is not provided on the channel region **17c.**

As shown in FIG. **3(b)****,** the TFT substrate **100a** further includes a plurality of storage capacitance lines **20** provided on the substrate **10** and a plurality of storage capacitance electrodes **21** facing the plurality of storage capacitance lines **20** with the insulating film **12** interposed therebetween. The storage capacitance lines **20** are formed by patterning a conductive film which is common with the scanning line **11** and the gate electrode **14G.** The storage capacitance electrodes **21** are formed by patterning a conductive film which is common with the signal line **13**, the source electrode **14S** and the drain electrode **14D.** As shown in FIG. 1, each storage capacitance electrode **21** is electrically connected to the drain electrode **14D** of the TFT **14** via a conductive member **22** extended from the drain electrode **14D.**

An inter-layer insulating film **19** is provided so as to cover the TFTs **14** and the signal lines **13** described above, and the pixel electrodes **15** are provided on the inter-layer insulating film **19.** As shown in FIG. **3(b)****,** each pixel electrode **15** is connected to the storage capacitance electrode **21** via a contact hole **19'** formed in the inter-layer insulating film **19,** and is electrically connected to the drain electrode **14D** of the TFT **14** via the storage capacitance electrode **21.**

In the TFT **100a** according to this embodiment, as shown in FIG. **3(c)****,** the insulating film **12** covering the scanning line **11** is a multiple layer insulating film including a first insulating layer **12a** and a second insulating layer **12b** provided on the first insulating layer **12a.** The first insulating layer **12a** is formed of an insulating material containing an organic component. By contrast, the second insulating layer **12b** is formed of an inorganic insulating material such as SiNₓ, SiOₓ or the like.

The first insulating layer **12a** is formed on most of the surface of the substrate **10** including the intersection of the scanning line **11** and the signal line **13** as shown in FIG. **3(c)****,** but is not formed in the vicinity of the channel region **17c** of the TFT **14** as shown in FIG. **3(a)****.** By contrast, the second insulating layer **12b** is formed on substantially the entire surface of the substrate **10,** and a part of the second insulating layer **12b** which is located between the gate electrode **14G** and the semiconductor layer **17** acts as the gate insulating film **16.** As understood from this, the multiple layer insulating film **12** includes a low stacking region **12R** excluding the first insulating layer **12a.** In FIG. **1****,** the low stacking region **12R** is the area surrounded by the dashed line. In this specification, the other area of the multiple layer insulating film **12** than the low stacking region **12R,** i.e., the area in which the first insulating layer **12a** and the second insulating layer **12b** are stacked is referred to as a "high stacking region".

As shown in FIG. **3(b)****,** the first insulating layer **12a** is not formed either between the storage capacitance line 20 and the storage capacitance electrode **21.** Thus, only the second insulating layer **12b** acts as a dielectric film for the storage capacitance. Namely, the multiple layer insulating film **12** has the low stacking region **12R** also between the storage capacitance line **20** and the storage capacitance electrode **21.**

In the TFT substrate **100a** according to this embodiment, as described above, the insulating film **12** covering the scanning line **11** is a multiple layer insulating film including the first insulating layer **12a** and the second insulating layer **12b,** and the multiple layer insulating film **12** has the low stacking region **12R** without the first insulating layer **12a** in the vicinity of the channel region **17c** of the TFT **14** and between the storage capacitance line **20** and the storage capacitance electrode **21.** Therefore, the capacitance generated at the intersection of the scanning line **11** and the signal line **13** can be decreased without lowering the driving capability of the TFT **14** or decreasing the value of the storage capacitance.

In order to sufficiently decrease the capacitance generated at the intersection of the scanning line **11** and the signal line **13,** it is preferable that the first insulating layer **12a** is thicker, and has a lower specific dielectric constant, than the second insulating layer **12b.**

The second insulating layer **12b** also acting as the gate insulting film **16** typically has a thickness of about 0.2 µm to about 0.4 µm and has a specific dielectric constant of about 5.0 to about 8.0. By contrast, it is preferable that the first insulating layer **12a** has a thickness of 1.0 µm or greater and 4.0 µm or less and has a specific dielectric constant of 4.0 or less.

As a material of first insulating layer **12a,** a spin-on glass material (so-called SOG material) containing an organic component is preferably usable. An SOG material having an Si-O-C bond as a skeleton or an SOG material having an Si-C bond as a skeleton is usable especially preferably. An SOG material is a material which can form a glass film (silica-based cover film) when applied by a method of spin coating or the like. An organic SOG material has a low specific dielectric constant and is easily formed into a thick film. Thus, use of an organic SOG material makes it easy to form the first insulating layer **12a** which has a low specific dielectric constant and is thick.

Materials usable as an SOG material having an Si-O-C bond as a skeleton include, for example, the materials disclosed in Japanese Laid-Open Patent Publications Nos. 2001-98224 and 6-240455 and DD1100 produced by Toray Dow Corning Silicone Kabushiki Kaisha which is disclosed in the proceedings of IDW'03, page 617. Materials usable as an SOG material having an Si-C bond as a skeleton include, for example, the materials disclosed in Japanese Laid-Open Patent Publication No. 10-102003.

Use of an organic SOG material containing a filler formed from silica (silica filler) as an SOG material can improve the crack resistance. The reason for this is that the generation of cracks is suppressed by silica filler in the film alleviating the stress. Silica filler typically has a particle diameter of 10 nm to 30 nm, and the mixing ratio of silica filler is typically 20% by volume to 80% by volume. A usable organic SOG material containing silica filler is, for example, LNT-025 produced by Catalysts & Chemicals Ind. Co., Ltd.

As described above, in the liquid crystal display device **100** according to this embodiment, the multiple layer insulating film **12** partially including the low stacking region **12R** is used. Therefore, the gate insulating film **16** can be made thinner without increasing the parasitic capacitance and thus the electric current driving capability of the TFT **14** can be improved. In addition, owing to the structure described below, the TFT **14** in this embodiment can prevent the decrease in the yield, which could be occurred by the gate insulating film **16** being thinned.

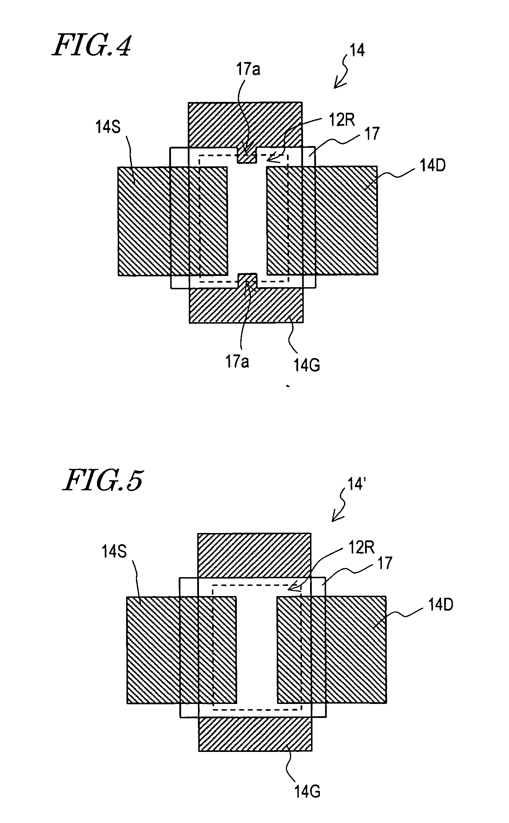

FIG. **4** shows the TFT **14** in this embodiment in enlargement. As shown in FIGS. **4** and **3(a)****,** the first insulating film **12a** is not removed from the entirety of the gate electrode **14G** but covers edges of the gate electrode **14G.**

In a general active matrix substrate, an electric current is likely to leak between an edge of the gate electrode and the source electrode/drain electrode. The leak occurs because a projection (called "hillock") is likely to be formed on the edge of the gate electrode when a conductive film is patterned to form the gate electrode and because the coverage at the edge of the gate electrode is likely to be deteriorated when the gate insulating film is formed on the gate electrode by CVD or the like. With the conventional active matrix substrate, it is made difficult to improve the electric current driving capability by means of thinning the gate insulating film, due to the leak occurring in this manner.

By contrast, in this embodiment, the edges of the gate electrode **14G** are covered with the first insulating layer **12a.** Therefore, even though the second insulating layer **12b** acting as the gate insulating film **16** is thinned (for example, to a thickness of 300 nm or less), the occurrence of a leak as described above can be suppressed.

A surface of the multiple layer insulating film **12** is concaved in the low stacking region **12R.** However, in this embodiment, the semiconductor layer **17** is provided both on the low stacking region **12R** and the high stacking region of the multiple layer insulating film **12** as shown in FIG. **3(a)****.** Therefore, even if the source electrode **14S** or the drain electrode **14D** is disrupted by any chance, the electric connection can be guaranteed.

With a structure in which the semiconductor layer **17** necessarily overlaps a part of the source electrode **14S** and a part of the drain electrode **14D** which overlap the low stacking region **12R** as in this embodiment, the occurrence of a defective leak between the source electrode/drain electrode and the gate electrode can be further suppressed.

The above-described effect of suppressing the defective leak is provided even by a structure in which the gate insulating film **16** is not much thinned (for example, a structure in which the gate insulating film **16** has a thickness of about 400 µm to about 500 µm). Such a thickness may be adopted depending on the dielectric constant or the coverage of the gate insulating film **16.**

In the TFT **14** in this embodiment, the semiconductor layer **17** and the low stacking region **12R** are arranged such that a path of an electric current flowing between the source electrode **14S** and the drain electrode **14D** necessarily passes a part of the semiconductor layer **17** which is located above the low stacking region **12R.** Specifically, as shown in FIG. **4****,** the semiconductor layer **17** has rectangular cutout portions **17a** extending in the direction of the channel width. Owing to this structure, the current path necessarily passes the part of the semiconductor layer **17** which is located above the low stacking region **12R.** In the case where there is a part of the current path which does not pass above the low stacking region **12R,** namely, in the case where a part of the current path passes above the high stacking region, a gate voltage is applied on the semiconductor layer **17** via the first insulating layer **12a** and the gate insulating film **16.** As a result, a sufficient gate voltage is not applied and thus it is made difficult to sufficiently switch the state of the semiconductor active layer. Now, for example, it is assumed that the gate insulating film **16** has a thickness of 200 nm and a specific dielectric constant of 7, and the first insulating layer **12a** has a thickness of 800 nm and a specific dielectric constant of 4. When a voltage of -10 V is applied to the gate electrode **14G,** a voltage of -4.1 V is applied to the semiconductor layer **17** where only the gate insulting layer **16** is provided. By contrast, where the gate insulting layer **16** and the first insulating layer **12a** are stacked, a voltage of only -0.9 V is applied to the semiconductor layer **17.** (In this example, the semiconductor layer has a thickness of 200 nm and a specific dielectric constant of 10.) For this reason, an increase in the off-current is suppressed by the current path necessarily passing a part of the semiconductor layer **17** located above the low stacking region **12R,** and thus a good off-characteristic is obtained.

By contrast, in a TFT **14'** shown in FIG. 5, the semiconductor layer **17** does not have the cutout portions **17a.** Due to this structure, there is a part of the current path which does not pass a part of the semiconductor layer **17** located above the low stacking region **12R** (i.e., passes only a part of the semiconductor layer **17** which is located above the high stacking region). As a result, the off-current increases and the off-characteristic is decreased. Hence, a good switching characteristic is not obtained.

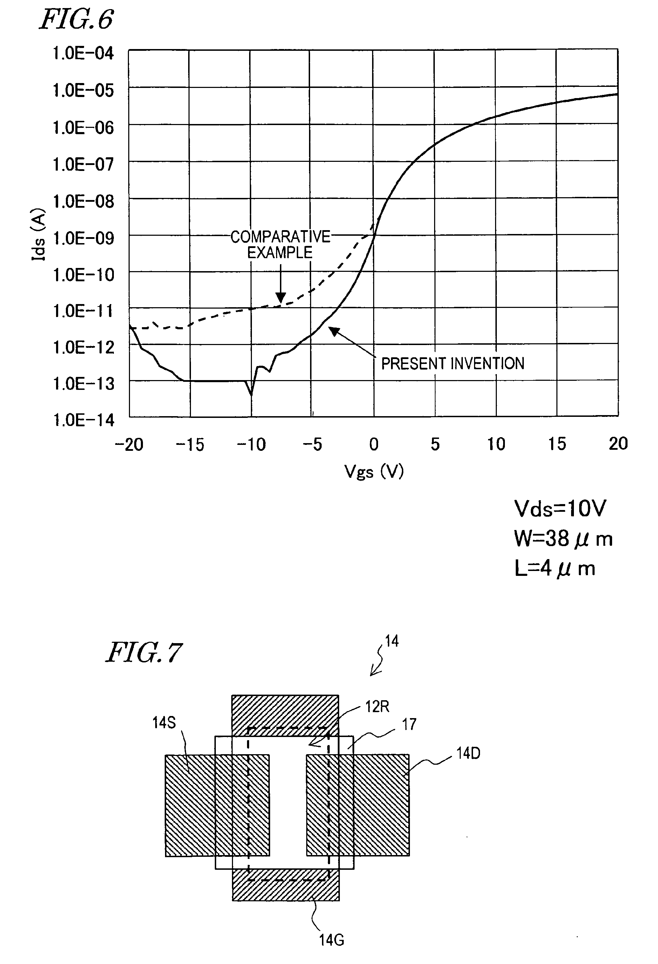

Regarding the TFT **14** shown in FIG. **4** and the TFT **14'** shown in FIG. **5**, the relationship between the gate electrode Vgs (V) and the drain current Ids (A) is shown in FIG. **6****.** The data shown in FIG. **6** is obtained where the drain voltage Vds is 10 V, the channel width W is 38 mm, and the channel length L is 4 µm. With the TFT **14** shown in FIG. **4****,** in the part of the semiconductor **17** which is located above the low stacking region **12R** where the current path passes, the channel region **17c** is away from the high stacking region by a distance of 1.5 µm. With the TFT **14'** shown in FIG. **5****,** the channel region **17c** is extended to overlap the high stacking region (with the overlapping width of 2 µm).

As shown in FIG. **6****,** with the TFT **14'** as the comparative example, the off-current exceeds 10 pA and so the off-characteristic is low. By contrast, with the TFT **14** according to the present invention, the off-current is significantly lowered and so the off-characteristic is significantly improved. As understood from this, the present invention can improve the off-characteristic of the thin film transistor.

FIG. **4** shows a structure in which the semiconductor layer **17** has the cutout portions **17a,** but the present invention is not limited to this structure. The effect of improving the off-characteristic is provided by setting the relative positions of the semiconductor layer **17** and the low stacking region **12R** such that a current path necessarily passes a part of the semiconductor layer **17** which is located above the low stacking region **12R.**

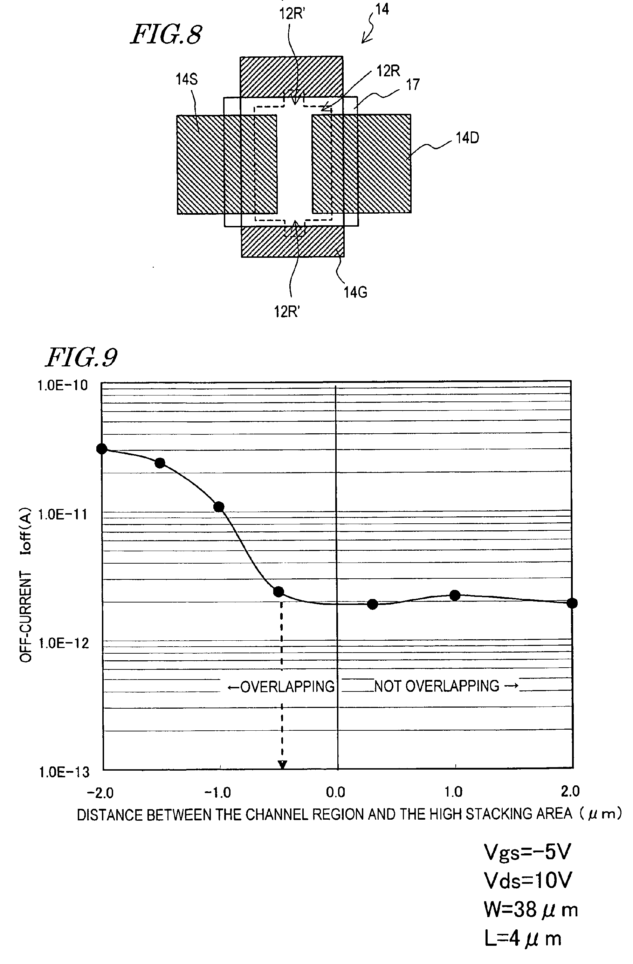

For example, as in the TFT **14** shown in FIG. 7, the width of the low stacking region **12R** in the direction of the channel width may be larger than the width of the semiconductor layer **17** in the direction of the channel width. Alternatively, as in the TFT **14** shown in FIG. **8****,** the low stacking region **12R** may have projections **12R'** which project in the direction of the channel width. In this manner, by a structure in which the semiconductor layer **17** has an area narrower than the low stacking region **12R** in the direction of the channel direction, the off-characteristic of the TFT **14** can be improved.

FIG. **9** shows the relationship between the distance of the channel region **17c** from the high stacking region and the off-current I_{off}. The off-current I_{off} shown in FIG. **9** is obtained where the gate voltage Vgs is -5 V and the drain voltage Vds is 10 V. As shown in FIG. **9****,** when the semiconductor layer **17** and the high stacking region overlap each other by 0.5 µm to 0 µm, the change in the off-current I_{off} is saturated and the value of the off-current I_{off} stays substantially constant. Accordingly, in order to provide the effect of improving the off-characteristic more certainly, it is preferable that in the part of the semiconductor layer **17** which is located above the low stacking region **12R,** the current path at least does not overlap the high stacking region. In consideration of the variance of alignment in an exposure step or the variance of pattern shifting in an etching step, it is preferable that the current path is away from the high stacking region by at least 0.5 µm in order to provide the effect of improving the off-characteristic even more certainly.

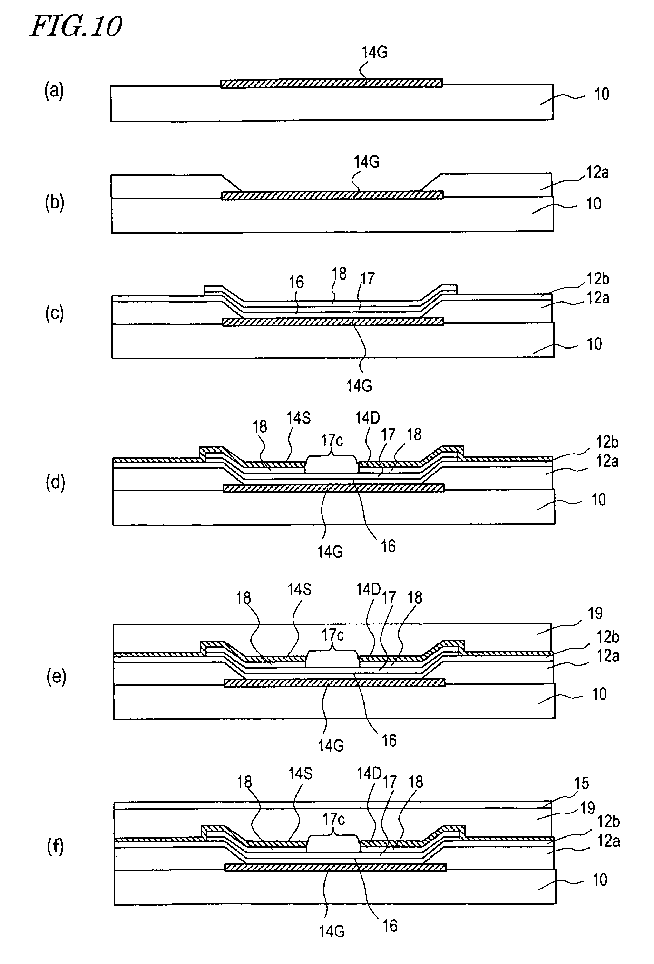

Now, an example of a method for producing the TFT substrate **100** will be described with reference to FIGS. **10(a)** through **(f).**

First, on the insulating substrate **10** such as a glass substrate or the like, a molybdenum (Mo) film, an aluminum (Al) film and a molybdenum (Mo) film are stacked by sputtering in this order. The stacked films are patterned by photolithography to form the gate electrode **14G** as shown in FIG. **10(a)****.** By this step, the scanning line **11** and the storage capacitance line **20** (not shown) are also formed. In this example, the thicknesses of the stacked Mo/Al/Mo films are 150 nm, 200 nm and 50 nm from the top.

Next, an organic SOG material is applied to the substrate **10** by spin coating, and then pre-baked and post-baked to form the first insulating layer **12a.** Then, as shown in FIG. **10(b)****,** predetermined parts of the first insulating layer **12a,** specifically, a part overlapping the gate electrode **14G** and a part overlapping the storage capacitance line **20** are removed by photolithography. The removal is performed such that the first insulating layer **12a** is left on edges of the gate electrode **14G** and edges of the storage capacitance line **20.** In this example, the organic SOG material is applied so as to have a thickness of 1.5 µm, then is pre-baked at 150°C for 5 minutes using a hot plate, and then is post-baked at 350°C for 1 hour using an oven. In this way, the first insulating layer **12a** having a specific dielectric constant of 2.5 is formed. In the case where etching is used, dry etching is conducted using a mixed gas of carbon tetrafluoride (CF₄) and oxygen (O₂).

Next, an SiNₓ film, an amorphous silicon (a-Si) film and an n⁺ amorphous silicon (n⁺ a-Si) film are consecutively stacked by CVD. Then, the a-Si film and the n⁺ a-Si film are patterned by photolithography (a part of the a-Si film and a part of the n⁺ a-Si film are removed by dry etching). In this way, as shown in FIG. **10(c)****,** the second insulating layer **12b** (a part of which acts as the gate insulating film **16**) and an island-like semiconductor structure formed of the intrinsic semiconductor layer **17** and the impurity added semiconductor layer **18** (referred to as a "semiconductor active layer area") are formed. In this example, the second insulating layer **12b** having a thickness of 0.4 µm and a specific dielectric constant of 7.0 is formed, and the intrinsic semiconductor layer **17** having a thickness of about 50 nm to about 200 nm and the impurity added semiconductor layer **18** having a thickness of about 40 nm are formed.

Then, an Mo film, an Al film and an Mo film are formed in this order by sputtering, and the stacked films are patterned by photolithography. In this way, the source electrode **14S,** the drain electrode **14D,** the signal line **13** and the storage capacitance electrode **21** are formed.

Next, as shown in FIG. **10(d)****,** a part of the impurity added semiconductor layer **18** which corresponds to a region **17c** to be the channel region is removed from the island-like semiconductor structure by dry etching, using the source electrode **14S** and the drain electrode **14D** as masks. By the step of removing the impurity added semiconductor layer **18,** a surface of the intrinsic semiconductor layer **17** is also removed by a small thickness.

Next, as shown in FIG. **10(e)****,** SiNₓ is provided by CVD to form the inter-layer insulating film **19** having a thickness of about 150 nm to about 700 nm, such that the inter-layer insulating film **19** covers substantially the entire surface of the substrate **10.** Then, the contact hole **19'** is formed by photolithography. The inter-layer insulating film **19** may be formed of an organic insulating material (for example, a photosensitive resin material) to a thickness of about 1.0 µm to about 3.0 µm. Alternatively, the inter-layer insulating film **19** may have a stacking structure in which a film formed of an inorganic insulating material such as SiN or the like and a film formed of an organic insulating material as described above are stacked.

Finally, an ITO film having a thickness of 100 nm is formed by sputtering, and the ITO film is patterned by photolithography (in the case where etching is used, wet etching is conducted). In this way, the pixel electrode **15** is formed as shown in FIG. **10(f)****.** The material of the pixel electrode **15** is not limited to a transparent conductive material such as ITO or the like mentioned here, and may be a light reflective metal material such as Al or the like.

In the manner described above, the TFT substrate **100a** is completed. By the method described here as an example, the multiple layer insulating film **12** including the first insulating layer **12a** having a thickness of 1.5 µm and a specific dielectric constant of 2.5 and the second insulating layer **12b** having a thickness of 0.4 µm and a specific dielectric constant of 7.0 is formed. Accordingly, the value per unit area of the capacitance generated at the intersection of the scanning line **11** and the signal line **13** is 1.48 × 10⁻⁵ pF/µm² .By contrast, in the case where only a gate insulating film having a thickness of 0.4 µm and a specific dielectric constant of 7.0 (corresponding to the first insulating film **12a** of this embodiment) is formed between the scanning line and the signal line as in the conventional active matrix substrate, the capacitance value per unit area is 1.55 × 10⁻⁴ pF/µm². By adopting the structure of this embodiment, the value of the capacitance generated at the intersection is reduced to 1/10 or less. Since the first insulating layer **12a** is also present between the scanning line **11** and the pixel electrode **15,** the capacitance value is also significantly reduced at the intersection of the scanning line **11** and the pixel electrode **15.**

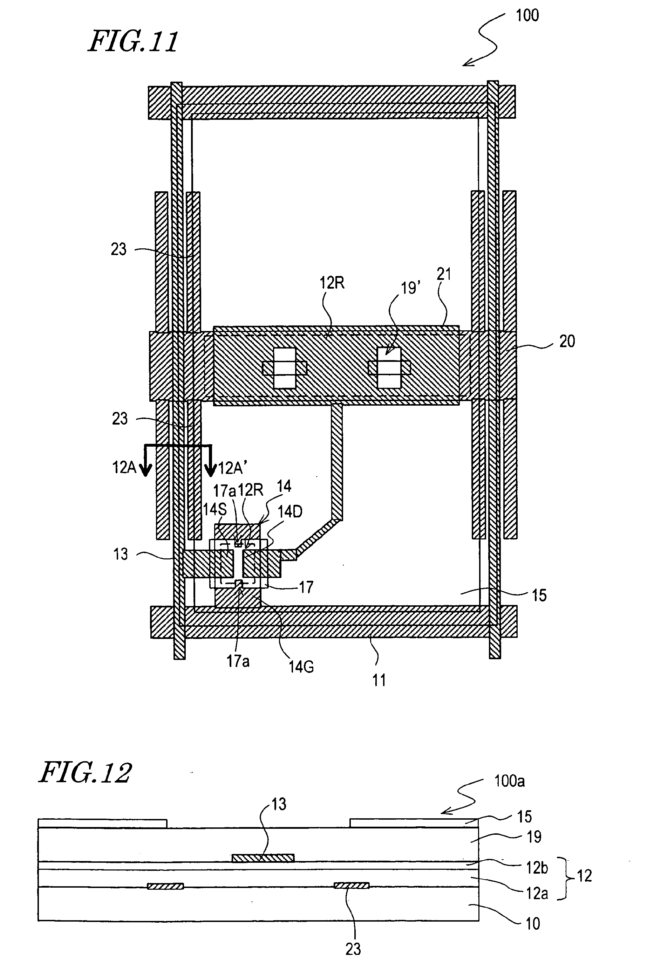

As shown in FIGS. **11** and **12****,** a plurality of shield electrodes **23** extending substantially in parallel to the signal lines **13** may be provided. The shield electrodes **23** are formed by patterning a conductive film which is common with the scanning lines **11.** Each shield electrode **23** is connected to the corresponding storage capacitance line **20** and is supplied with a certain potential. Hereinafter, problems which may arise when the shield electrode **23** is not provided and advantages obtained by providing the shield electrode **23** will be described.

Where the shield electrode **23** is not provided, a static capacitance is formed between the pixel electrode **15** and the signal line **13.** Namely, from the viewpoint of electric force lines in the pixel area, the electric force lines are formed so as to connect the pixel electrode **15** and the counter electrode as well as to connect the pixel electrode **15** and the signal line **13.** Hence, the potential of the pixel electrode **15,** which needs to be kept constant in one frame, is changed by the influence of the potential of the signal line **13.**

By contrast, where the shield electrode **23** is provided, the electric force lines directed toward the signal line **13** from the pixel electrode **15** can be guided to the shield electrode **23,** which can prevent a capacitance from being formed between the pixel electrode **15** and the signal line **13.** Therefore, the potential of the pixel electrode **15** can be suppressed from being changed by the influence of the potential of the signal line **13.** In other words, the shield electrode **23** has a function of shielding the pixel electrode **15** against an electric field generated by the signal line **13.**

In order to guide as many electric force lines as possible from the pixel electrode **15** to the shield electrode **23** and thus to effectively suppress the change in the potential of the pixel electrode **15,** it is preferable that the shield electrode **23** is located closer to the signal line **13** than an edge of the pixel electrode **15** as shown in FIG. **12****.** In a liquid crystal display device, an area between the signal line **13** and the pixel electrode **15** is an area where light leaks. Therefore, it is preferable to provide a light shielding body (also referred to as a "black matrix") on the counter substrate to shield this area. By locating the shield electrode **23** so as to overlap the edge of the pixel electrode **15** as shown in FIG. **12****,** a narrower light shielding body is usable on the counter substrate, which improves the numerical aperture and the transmittance of the liquid crystal display device.

(EMBODIMENT 2)

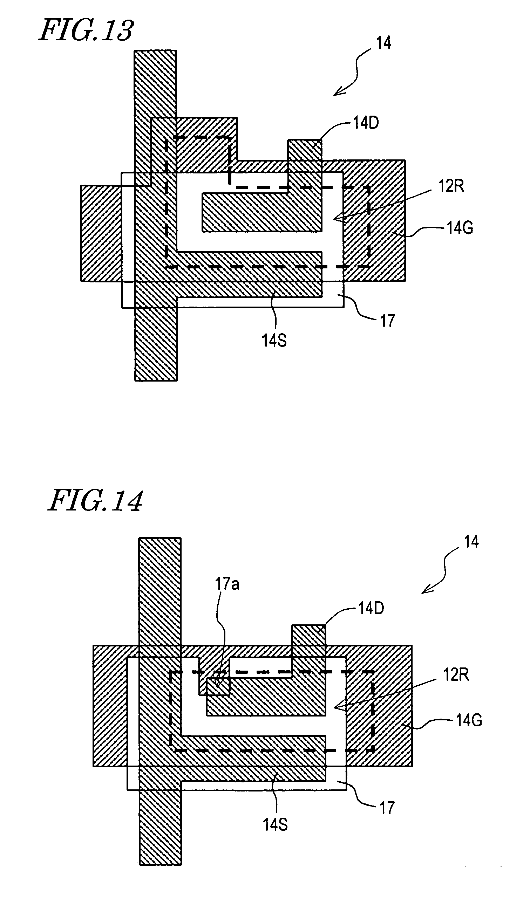

FIGS. **13** and **14** schematically show a thin film transistor (TFT) **14** in this embodiment. In the thin film transistor **14** in this embodiment, the channel region **17c** is formed in an L shape as shown in FIGS. **13** and **14****.**

With the TFT **14** of such an L-shaped structure also, the occurrence of a leak between the source electrode/drain electrode and the gate electrode can be suppressed by covering the edges of the gate electrode **14G** with the first insulating layer **12a.**

The effect of improving the off-characteristic is provided by setting the relative positions of the semiconductor layer **17** and the low stacking region **12R** such that a current path necessarily passes a part of the semiconductor layer **17** which is located above the low stacking region **12R.** For example, with a structure shown in FIG. **13****,** by forming the low stacking region **12R** in an L shape, the width of the low stacking region **12R** in the direction of the channel width is made larger than the width of the semiconductor layer **17** in the direction of the channel width. With a structure shown in FIG. **14****,** a cutout portion **17a** extending in the direction of the channel width is formed in the semiconductor layer **17.**

With the structures shown in FIGS. **13** and **14****,** a part of the source electrode **14S** which overlaps the low stacking region **12R** has a smaller area size than a part of the drain electrode **14D** which overlaps the low stacking region **12R.** Namely, the source electrode **14S** and the drain electrode **14D** are made asymmetric in shape to each other and the electrode having a smaller area size overlapping the low stacking region **12R** is selected as the source electrode. With a structure of the present invention with which the leak is significantly suppressed at the edges of the gate electrode **14G,** the occurrence rate of a leak is determined substantially in proportion to the area sizes of the parts of the source electrode **14S** and the drain electrode **14D** which overlap the low stacking region **12R.** A leak occurring between the gate electrode **14G** and the drain electrode **14D** causes a point defect, whereas a leak occurring between the gate electrode **14G** and the source electrode **14S** causes a line defect. By arranging the source electrode **14S** to overlap the low stacking region **12R** by a smaller area size than the drain electrode **14D,** the occurrence rate of a line defect can be lowered.

(EMBODIMENT 3)

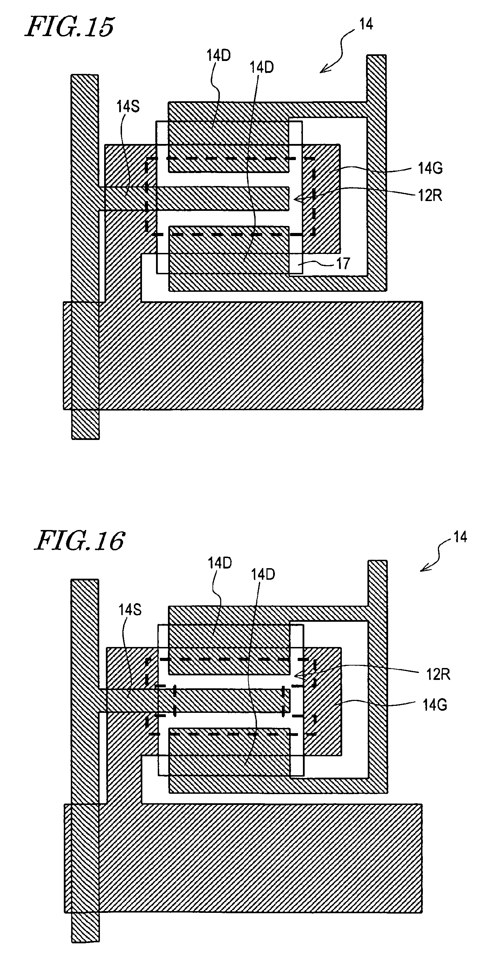

FIGS. **15** and **16** schematically show a TFT **14** in this embodiment. As shown in FIGS. **15** and **16****,** the thin film transistor **14** in this embodiment includes two drain electrodes **14D,** and the source electrode **14S** is located between the two drain electrodes **14D.** With such a structure, even if the alignment of the photomasks is shifted, the change in the gate-drain capacitance can be counteracted between the two drain electrodes **14D.** Therefore, the change in the gate-drain capacitance of the entire TFT **14** can be suppressed.

With the TFT **14** of such a structure also, the occurrence of a leak between the source electrode/drain electrode and the gate electrode can be suppressed by covering the edges of the gate electrode **14G** with the first insulating layer **12a.** The effect of improving the off-characteristic is provided by setting the relative positions of the semiconductor layer **17** and the low stacking region **12R** such that a current path necessarily passes a part of the semiconductor layer **17** which is located above the low stacking region **12R.**

With a structure shown in FIG. **15****,** the low stacking region **12R** is provided in a rectangular shape. With a structure shown in FIG. **16****,** the low stacking region **12R** is provided in a rectangular shape with cutout portions. Specifically, as shown in FIG. **16****,** parts of the low stacking region **12R** overlapping the source electrode **14S** are partially cutout, and thus the low stacking region **12R** has an H shape. As a result, the first insulating layer **12a** is present in a part of the channel region which is located between the source electrode **14S** and the gate electrode **14G.** Accordingly, the gate-source capacitance is lower with the structure shown in FIG. **16** than with the structure shown in FIG. **15****.**

In this specification, the present invention is described using a liquid crystal display device including a liquid crystal layer as a display medium and an active matrix substrate for the liquid crystal display device as an example. The present invention is not limited to these and is preferably usable for an active matrix substrate of various display devices such as an organic EL display device and the like.

### INDUSTRIAL APPLICABILITY

According to the present invention, the electric current driving capability of a thin film transistor can be improved without the yield being decreased due to a defective leak between the source electrode/drain electrode and the gate electrode or due to a decrease in the off-characteristic.

A thin film transistor according to the present invention has a superb electric current driving capability and is preferably usable for an active matrix substrate of various display devices.

## Claims

1. A thin film transistor, comprising:
a gate electrode;
an insulating film covering the gate electrode;
a semiconductor layer provided on the insulating film; and
a source electrode and a drain electrode provided on the insulating film and the semiconductor layer;
wherein:
the insulating film is a multiple layer insulating film including a first insulating layer and a second insulating layer provided on the first insulating layer;
the multiple layer insulating film has a low stacking region excluding the first insulating layer and a high stacking region in which the first insulating layer and the second insulating layer are stacked;
the first insulating layer is provided so as to cover at least an edge of the gate electrode;
the semiconductor layer is provided on both the low stacking region and the high stacking region of the multiple layer insulating film; and
the semiconductor layer and the low stacking region are arranged such that a path of a current flowing between the source electrode and the drain electrode necessarily passes a part of the semiconductor layer which is located above the low stacking region.

2. The thin film transistor of claim 1, wherein the path of the current, in the part of the semiconductor layer which is located above the low stacking region, is away from the high stacking region by at least 0.5 µm.

3. The thin film transistor of claim 1 or 2, wherein the semiconductor layer has a cutout portion extending in a direction of a channel width.

4. The thin film transistor of claim 1 or 2, wherein a width of the low stacking region in a direction of a channel width is larger than a width of the semiconductor layer in the direction of the channel width.

5. The thin film transistor of claim 1 or 2, wherein the low stacking region has a projection which projects in a direction of a channel width.

6. A thin film transistor, comprising:
a gate electrode;
an insulating film covering the gate electrode;
a semiconductor layer provided on the insulating film; and
a source electrode and a drain electrode provided on the insulating film and the semiconductor layer;
wherein:
the insulating film is a multiple layer insulating film including a first insulating layer and a second insulating layer provided on the first insulating layer;
the multiple layer insulating film has a low stacking region excluding the first insulating layer and a high stacking region in which the first insulating layer and the second insulating layer are stacked;
the first insulating layer is provided so as to cover at least an edge of the gate electrode; and
the semiconductor layer is provided on both the low stacking region and the high stacking region of the multiple layer insulating film, and has an area having a smaller width than the low stacking region in a direction of a channel width.

7. The thin film transistor of any one of claims 1 through 6, wherein the semiconductor layer overlaps a part of the source electrode and a part of the drain electrode which overlap the low stacking region.

8. The thin film transistor of any one of claims 1 through 7, wherein the part of the source electrode which overlaps the low stacking region has a smaller area size than the part of the drain electrode which overlaps the low stacking region.

9. The thin film transistor of any one of claims 1 through 8, wherein the first insulating layer is formed of an insulating material containing an organic component, and the second insulating layer is formed of an inorganic insulating material.

10. The thin film transistor of any one of claims 1 through 9, wherein the first insulating layer is thicker, and has a lower specific dielectric constant, than the second insulating layer.

11. The thin film transistor of any one of claims 1 through 10, wherein the first insulating layer has a thickness of 1.0 µm or greater and 4.0 µm or less.

12. The thin film transistor of any one of claims 1 through 11, wherein the first insulating layer is formed of a spin-on glass (SOG) material having a specific dielectric constant of 4.0 or less.

13. An active matrix substrate, comprising:
a substrate;
a plurality of thin film transistors of any one of claims 1 through 12 which is provided on the substrate;
a plurality of scanning lines electrically connected respectively to gate electrodes of the plurality of thin film transistors; and
a plurality of signal lines electrically connected respectively to source electrodes of the plurality of thin film transistors.

14. A display device, comprising the active matrix substrate of claim 13.
